# EUROPEAN PATENT APPLICATION

(11) **EP 1 075 022 A1**
(43) Date of publication of application: **07.02.2001**
(21) Application number: 99830508.0
(22) Date of filing: 04.08.1999
(51) Int. Cl.: H01L 21/56

(54) **Offset edges mold for plastic packaging of integrated semiconductor devices**

(71) Applicant: STMicroelectronics S.r.l., 20041 Agrate Brianza (Milano) (IT)
(72) Inventor: Poinelli, Renato, 23880 Casatenovo (IT); Mazzola, Mauro, 24040 Calvenzano (IT); Brioschi, Roberto, 20099 Sesto San Giovanni (IT)
(74) Representative: Pellegri, Alberto

(57) **Abstract**

A mold for plastic packaging of an integrated semiconductor device composed of two half shells closing on a perimetral dam-bar of a die-stamped assembly metal frame of the semiconductor dice disposed between the two half shells of the mold, the depressed central pad defining, at least along the zone of injection of the resin a slit between the perimetral portion of the frame and the central pad thereof through which the resin injected through an inlet channel flows to fill the upper part of the cavity of the mold, the edge of said central pad defining said flow slit being bent upward to form a spoiler intercepting the resin stream and directing part of the resin toward the relatively narrow space between the bottom of said depressed central pad of the frame and the lower half shell of said mold, has the inner edge of the upper half shell of the mold, that defines the internal cavity along the side of injection of the resin inwardly offset in respect to the opposite inner edge of the lower half shell of the mold. This offsetting cooperates with the spoiler in restricting the aperture of the flow slit.

## Description

The present invention relates to techniques for plastic packaging of integrated circuits.

Miniaturization compels a generalized reduction of the dimensions of integrated devices which are commonly packaged in an encapsulating resin by injection molding during which the two halves of the mold close on a so-called "dam-bar" of the assembling metal frame of the semiconductor chip or dice.

According to consolidated assembling techniques, the dice is bonded onto a lowered reduced central isle of the die-stamped metal frame such to have the upper surface of the dice coplanar to the peripheral portion of the frame where a plurality of leads is patterned by the die-stamping operation. The wires for connecting the metal pads defined on the upper side of the dice to the respective leads of the metal frame are then welded by conventional thermosonic techniques.

Once the assembling process is completed, the frames carrying the dice are placed between the two halves of the molds and resin is injected into the mold cavity through an inlet channel defined along one side of the mold.

In correspondence to the inlet channel of the resin into the cavity of the mold, the metal frame has a slit, typically between a raised edge of the depressed central isle of the frame onto the top side of which the semiconductor dice is bonded, and a perimetral dam-bar of the patterned metal frame onto which the two halves of the mold close. The resin is injected through an inlet mouth defined in the lower half shell of the mold and flows through the slit thus filling also the upper cavity of the mold, encapsulating the dice and the connecting wires.

Because the gap between the bottom of the depressed central isle of the metal frame and the lower half of the mold is relatively small, the resin injected into the mold tends to fill preferentially the relatively ampler space defined in the upper portion of the mold cavity. This may cause an incomplete or partial filling of the restricted space underneath the depressed central pad or isle of the metal frame.

This problem may be overcome by bending upward the edge of the central pad of the metal frame which defines the passage through which the plastic resin flows toward the upper portion of the cavity of the mold, such to constitute a "spoiler" baffle that intercepts and direct part of the fluid resin toward the bottom part of the mold. This promotes the complete filling also of the lower restricted space of the mold, underneath the depressed central pad of the metal frame that supports the semiconductor dice coplanarly with the metal; this geometric arrangement being essential to facilitate the welding of the connecting wires.

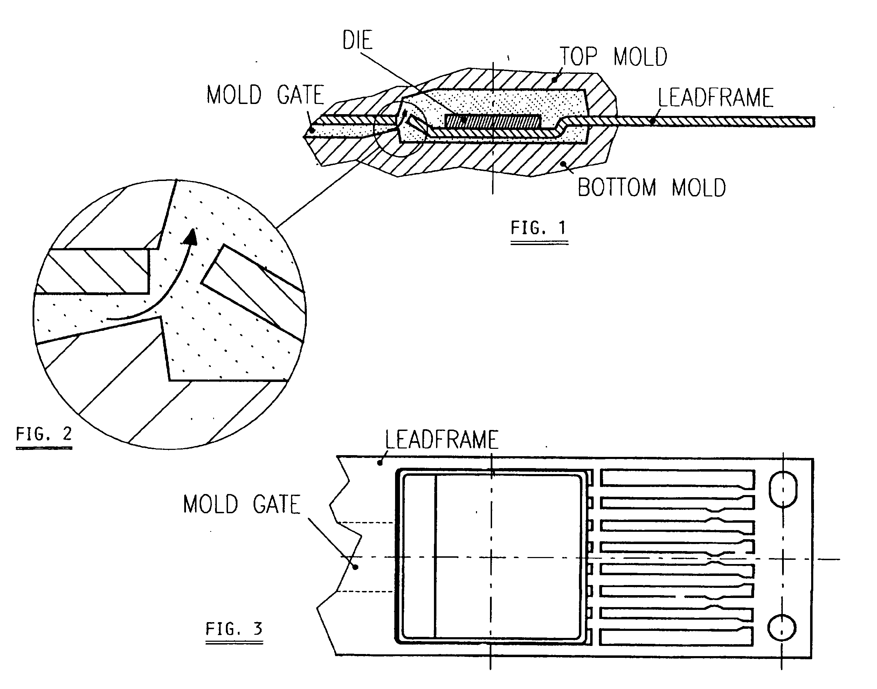

As dimensions are scaled down, this arrangement, as graphically shown in Figures 1, 2 and 3, becomes insufficient to ensure the complete filling of the increasingly restricted space underneath the depressed central pad of the metal frame that supports the semiconductor dice.

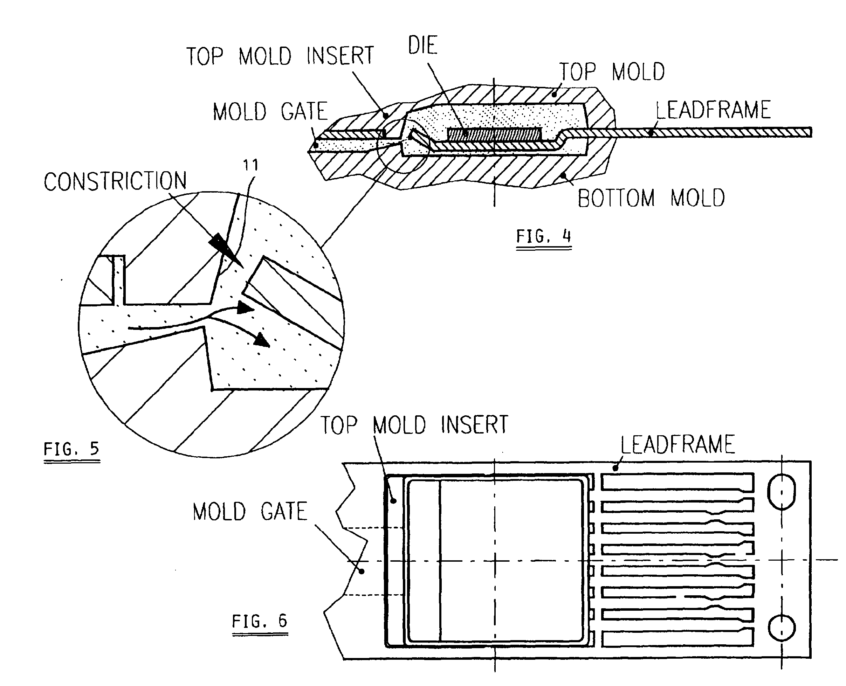

Therefore, the upper half shell of the mold may be equipped with a special insert or protrusion in the inlet of the resin shaped such to partially restrict the slit through which the resin flows toward the upper cavity of the mold. In practice, this protruding insert reduces the width of the slit through which the resin flows. This known solution is shown in Figures 4, 5 and 6.

This known solution for promoting a complete filling of the mold cavity has drawbacks.

The mold no longer closes entirely on an uninterrupted perimetral dam-bar of the stamped metal frame, but along the side of the mold where the resin enters into the mold, the closure takes place by direct abutment of the two halves of the mold.

Despite the mechanical precision of the molds, it is almost inevitable the occurrence of "flashes" of resins due to an imperfect sealing of the mold. This problem is accentuated by the unavoidable inconstancy of the thickness of the stamped metal frames.

The presence of resin flashes due to an imperfect sealing and their breaking off that is likely to occur during the successive finishing steps of the packaging process, release particles of resin that accumulate themselves into delicate automation mechanisms leading to malfunctionings.

Moreover, it is easily recognized the accentuated criticity of the design and of the machining of such molds and overall their relatively high cost.

The above noted drawbacks and difficulties are effectively overcome by the present invention whose approach is of reducing the width of the resin flow slit that is defined in correspondence to the inlet zone of the resin by displacing inward by an adequate distance the edge of the upper half shell of the mold, along the side of injection of the resin, in respect to the edge of the opposite side of the lower half shell of the mold, deliberately creating a disalignment or mismatch of the two halves of the mold that essentially define one side of the packaging resin body of the device.

In practice, the inner edge of the upper half of the mold reaches a more inward position than the inner edge of the cooperating opposite side of the lower half of the mold.

The result is to restrict efficiently the width of the slit through which the fluid resin flows toward the upper part of the cavity of the mold while maintaining the perimetral sealing of the mold uninterruptingly over the perimetral dam-bar of the die-stamped assembly metal frame.

The mold of the invention has proven itself outstandingly effective in preventing the occurrence of resin flashes as well as in ensuring a complete filling of all the empty spaces of the cavity of the mold, and in particular of the narrow space underneath the depressed central pad of the assembly metal frame.

The different aspects and advantages of the invention will become even clearer trough the following description and by referring to the attached drawings, wherein:
**Figures 1, 2** and **3** as already said, are a section view, an enlarged detail view and a plan view, respectively, of a mold used for plastic packaging of a semiconductor device;
**Figures 4, 5** and **6**, as already said, are a section view, an enlarged detail view and a plan view, respectively, of a mold for packaging a device according to a known technique for checking the preferred direction of flow of the resin toward the upper cavity of the mold;
**Figures 7, 8** and **9** are a section view, an enlarged view in details and a plan view, respectively, of a mold made according to the present invention.

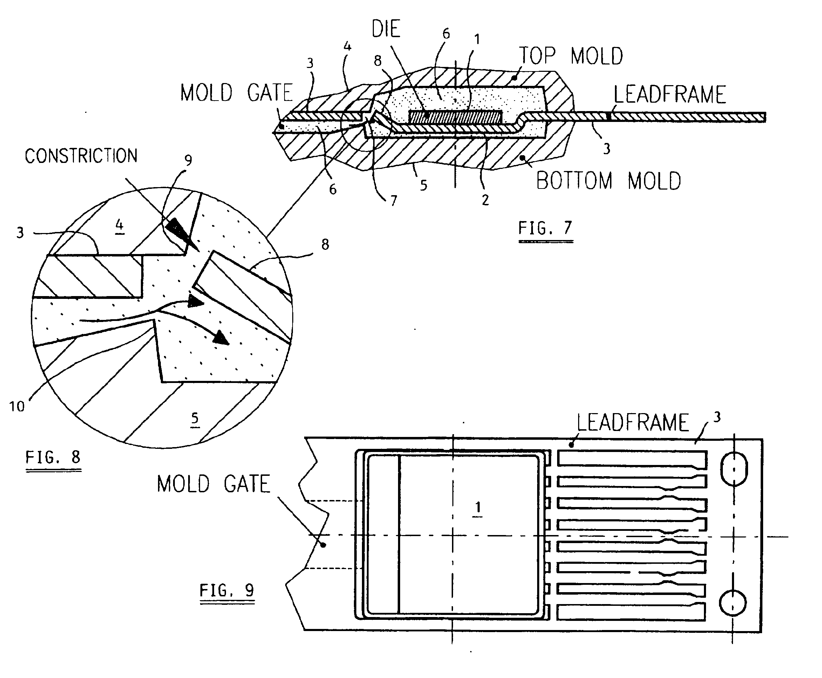

With reference to Figures 7, 8 and 9, a semiconductor die 1, already assembled onto the depressed central pad 2 of the metal frame 3, after having welded the connecting wires (not shown in the drawings) on the metal pads on the surface of the dice 1 and on the respective metal leads defined in the die-stamped frame 3, is closed in a mold.

The upper half shell 4 and the lower half shell 5 of the mold define a cavity 6 whose dimensions are adequate to accommodate the dice 1, the inner parts of the metal frame 3 and the connecting wires to be packaged in a body of encapsulating resin.

As it may be observed that, according to a common conformation of the metal frame 3, along the side of the cavity defined by the mold in which an inlet channel 6 for injecting the resin in the cavity of the mold is formed (typically in the lower half shell 5 of the mold), there is a passage or slit 7 between the metal body of the depressed central pad 2 of the frame and the adjacent perimetral area of the metal frame 3 so that the resin may flow upward to fill the upper cavity of the mold encapsulating the dice 1 and the connecting wires to the leads of the assembly frame 3.

Conventionally, the edge 8 of the central pad of the metal frame 2, cooperating in defining the flow passage or slit 7 of the resin, is bent upward to form a deflector or spoiler, intercepting the stream of resin and directing part of it to flow downward beneath the central pad 2 of the frame in order to fill completely the restricted space between the bottom of the depressed central pad of the metal frame and the lower half shell of the mold.

According to the present invention, the width of the slit 7 through which the resin flows toward the upper part of the mold is reduced to contrast a preferential direction of flow of the resin toward the ampler upper cavity by advancing the inner edge 9 of the upper half shell 4 of the mold along the side where there is the inlet channel of the resin, in respect to the corresponding inner edge 10 of the lower half shell 5 of the mold.

In other words, the inner edges of the two opposite sides of the two halves of the mold are offset. In practice, the edge of the upper half of the mold 4 reaches a position that is more advanced inward than the edge of the lower half 5 of the mold.

Such a "discontinuity" remains evident on the body of resin of the resulting package without any undesired effect.

Differently from what occurs in molds made according to prior techniques, depicted in Figures 4, 5 and 6 in which a special protrusion or tooth 11 determined the required reduction of the width of the flow passage 7 through which the resin flows toward the upper part of the mold cavity, cooperates in sealing the mold around the injection channel of the resin, by abutting against cooperating surfaces of the lower half shell of the mold, in the case of the mold structure of the invention of Figures 7, 8 and 9, the sealing of the mold occurs entirely over the conventionally dedicated uninterrupted perimetral dam-bar of the die-stamped metal frame 3.

Of course, the mold material, the type and rheological characteristics of the encapsulating resin, as well as the material/s that constitute the assembly metal frame may be the same that are commonly used in the industry. Although the illustrated example refers to the case of a "Single-In-Line" package, it is evident that the peculiar offset edges conformation of the two half cells of the mold along the side where the resin is injected and the relative slit 7 of the metal frame for permitting to the resin to flow through it and fill the upper part of the cavity of the mold, may be advantageously employed in innumerable other types of molds for other than "Single-in-Line" packages.

The edge that defines the cavity of the upper half shell of the mold, along the entire side or along a part of it where the resin is injected, is offset inwardly by a fraction of the width of the slit defined in the assembly metal frame through which the resin injected through the inlet channel defined in the lower half shell of the mold may flow and fill the upper space of the cavity of the mold.

In the illustrated example, the equivalent or effective width of the slit patterned and formed by bending in the metal frame, was 0.75 mm and the restriction created by advancing the edge of the upper half shell of the mold accounted to 53% of the width of the slit, being of about 0.40 mm.

Generally, and depending of the specific rheological and geometric parameters, the inward offsetting of the edge of the upper half of the mold in respect to the opposite edge of the lower half of the mold, may range between 20% and 70% of the width of the slit defined in the metal frame.

## Claims

1. A mold for plastic packaging of an integrated semiconductor device composed of two half shells closing on a perimetral dam-bar of a die-stamped assembly metal frame of the semiconductor dice disposed between the two half shells of the mold, said dice being supported onto a central pad of the frame depressed in respect to the plane of the perimetral portion of the patterned frame, the central pad defining, at least along the zone of injection of the resin a slit between said perimetral portion and the central pad through which the resin injected through an inlet channel flows to fill the upper part of the cavity of the mold, the edge of said central pad defining said flow slit being bent upward to form a spoiler intercepting the resin stream and directing part of the resin toward the relatively narrow space between the bottom of said depressed central pad of the frame and the lower half shell of said mold, characterized in that
the upper half shell of the mold has the inner edge that defines the internal cavity along the side of injection of the resin inwardly offset in respect to the opposite inner edge of the lower half shell of the mold, and cooperating with said spoiler to restrict the aperture of the flow slit.

2. The mold according to claim 1, characterized in that the inward offsetting of the inner edge of the upper half shell of the mold is comprised between 20% and 70% of the width of said flow slit.
